(19) Europäisches Patentamt / European Patent Office / Office européen des brevets

(11) **EP 3 251 155 B1**

(12) **EUROPEAN PATENT SPECIFICATION**

(45) Date of publication and mention
of the grant of the patent:
**17.07.2019 Bulletin 2019/29**

(51) Int Cl.:
***H01L 31/101*** (2006.01)

(21) Application number: **16705584.7**

(86) International application number:
**PCT/IB2016/050456**

(22) Date of filing: **29.01.2016**

(87) International publication number:
**WO 2016/120837 (04.08.2016 Gazette 2016/31)**

(54) **ALL-ELECTRICAL PLASMON DETECTOR**

VOLLELEKTRISCHER PLASMONENDETEKTOR

DÉTECTEUR DE PLASMON TOUT ÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.01.2015 IT TO20150064**

(43) Date of publication of application:
**06.12.2017 Bulletin 2017/49**

(73) Proprietors:
• **Fondazione Istituto Italiano di Tecnologia
16163 Genova (IT)**
• **Scuola Normale Superiore
56126 Pisa (IT)**

(72) Inventors:
• **POLINI, Marco
I-56123 Pisa (IT)**
• **TORRE, Iacopo
I-56125 Pisa (IT)**
• **TOMADIN, Andrea
I-34070 MARIANO DEL FRIULI (Gorizia) (IT)**
• **KRAHNE, Roman Mark
I-16131 Genova (IT)**

• **PELLEGRINI, Vittorio
I-55010 Lucca (IT)**

(74) Representative: **Vanzini, Christian et al
Jacobacci & Partners S.p.A.
Corso Emilia 8
10152 Torino (IT)**

(56) References cited:
**US-A1- 2004 173 865     US-A1- 2012 280 345**

• **BERINI P ET AL: "Long-Range Surface Plasmons
Along Membrane-Supported Metal Stripes", IEEE
JOURNAL OF SELECTED TOPICS IN QUANTUM
ELECTRONICS, IEEE SERVICE CENTER,
PISCATAWAY, NJ, US, vol. 14, no. 6, 1 November
2008 (2008-11-01), pages 1479-1495,
XP011344166, ISSN: 1077-260X, DOI:
10.1109/JSTQE.2008.918944**
• **DE LEON N P ET AL: "Quantum Plasmonic
Circuits", IEEE JOURNAL OF SELECTED TOPICS
IN QUANTUM ELECTRONICS, IEEE SERVICE
CENTER, PISCATAWAY, NJ, US, vol. 18, no. 6, 1
November 2012 (2012-11-01), pages 1781-1791,
XP011485969, ISSN: 1077-260X, DOI:
10.1109/JSTQE.2012.2197179**

**Description**

The present invention relates to a plasmon detector comprising a strip-shaped waveguide of material adapted to propagate a plasmon when excited by ah incident beam of light, said waveguide being adapted to guide the plasmon along its length direction.

Document US2004/173865 discloses plasmon detectors.

Plasmonics reduces the footprint of light well below the diffraction limit and therefore provides a very promising alternative for on-chip photonics. For practical purposes, the interfacing of plasmonic modules with electronic ones is of crucial importance. So far, optical readouts of plasmon signals, as well as conversion of plasmons to electrical signals using photodetector devices have been proposed and tested, as well as the detection via the local heating induced by the plasmon that switches the resistivity of a nearby superconducting wire from the superconducting to the normal state. All these techniques require sophisticated device fabrication, and rely on a conversion of the plasmon energy either to excite charges in a semiconductor over the band gap or to thermal energy.

Plasmon detectors have been proposed which use a metal waveguide and are based on two-plasmon quantum interference [1]. The drawbacks of this type of devices are that the detection is not on-chip and that the device fabrication is challenging.

On-chip superconductor plasmon detectors have also been proposed [2]. In this device the plasmons are excited using the single-photon emission of an optically emitting quantum dot, and propagate for several micrometers along plasmon waveguides made of polycrystalline gold stripes electrically insulated from the NbN (Niobium nitride) by a dielectric. By coupling these plasmon waveguides to a superconducting single photon detector, the device is able to perform an on-chip detection of a single plasmon. The device must be maintained at cryogenic temperatures in order to guarantee the superconducting properties.

US 7 495 230 discloses an integrated plasmon detector formed by a top layer of material adapted to generate a plasmon when excited by a beam of light incident onto its surface, an interface layer joined to the top layer opposite from the surface of the top layer and adapted to slow polarons emitted by the plasmon to thermal electrons, and a collector layer joined to the interface layer opposite from the top layer and adapted to collect the thermal electrons from the interface layer. Therefore the detection relies on a secondary effect invoked by the plasmon, leading to a quite complex detection scheme, which requires a calibration for the coupling of the secondary effect associated to the plasmon.

Ref. 3 discloses an all-electrical SPP detection technique based on the near-field coupling between guided plasmons and a nanowire field-effect transistor. Electrical detection of the plasmon emission from an individual colloidal quantum dot coupled to an SPP waveguide is performed. The device might be used in on-chip optical sensing applications and is a key step towards 'dark' optoplasmonic nanocircuits in which SPPs can be generated, manipulated and detected without involving far-field radiation. The detection in this device requires that the plasmon frequency is larger than the semiconductor band gap in order to have a signal. Moreover, the device requires the positioning of the nanowire on the plasmonic waveguide, and near-field coupling of the plasmon to the semiconductor wire. This leads to quenching of the plasmon caused by the detection mechanism.

One object of the invention is to provide an all-electrical plasmon detector that can at least partially overcome the drawbacks of the prior art devices.

Another object of the invention is to provide a plasmon detector that is more efficient and easier to be produced.

In accordance with this object, the invention proposes a plasmon detector as recited in claim 1 and corresponding method as recited in claim 6. Further advantageous embodiments are recited in the dependent claims.

The particular architecture of the detector according to the invention allows all-electrical detection of plasmons in a two-dimensional waveguide, in which the charge carrier dynamics can be described by hydrodynamic theory. In the proposed scheme, all-electrical detection is enabled by the intrinsic non-linear terms in the hydrodynamic equations that describe carrier transport in a 2D massless Dirac fermion (MDF) liquid, like it is the case in graphene waveguides. Non-linearities enable the emergence of a rectified (i.e. DC) component of the AC electric field of a propagating plasmon, which can be measured by a suitable geometry of ohmic contacts placed along the waveguide.

On the one hand, the device of the invention is more efficient than known devices, as it is based on a one-step, direct detection principle. Furthermore it is more versatile than the semiconductor based devices, as it does not require the plasmon energy to be higher than the band gap energy of the semiconductor. No detection limit is imposed on plasmon frequency.

On the other hand, the architecture of the device of the invention is far more simple than known devices, as it is required in principle just a waveguide layer and ohmic contacts. This results in a simpler and more cost-effective fabrication process than the prior art devices.

Further characteristics and advantages of the proposed device will be presented in the following detailed description, which refers to the attached drawings, provided purely by way of non-limiting example, in which:

- Figure 1 is a schematic, perspective view of a plasmon detector according to the invention;

- Figure 2 is a cross-sectional view of a detail of the device of Figure 1, taken at the position of one of its probe electrodes;

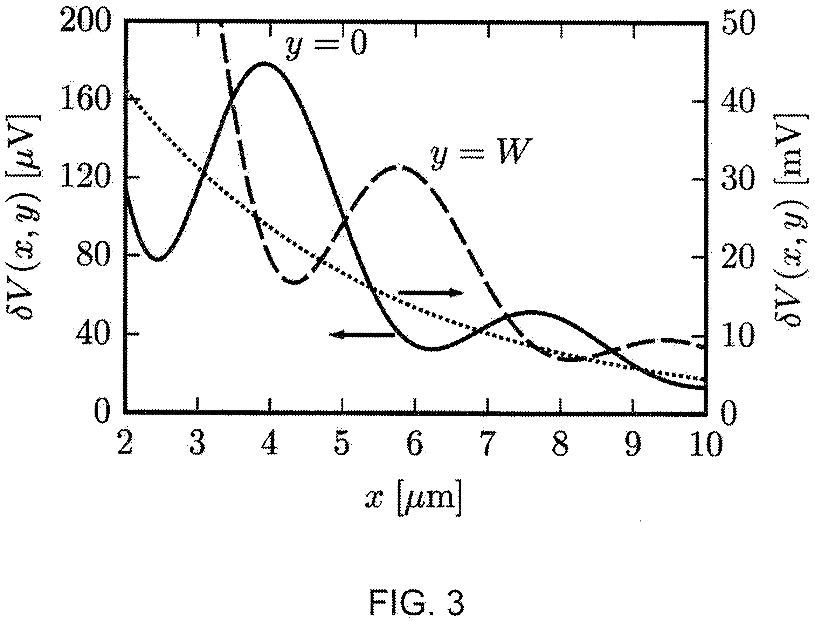

- Figure 3 is a graph showing: (Left vertical axis) The DC potential $\delta V(\boldsymbol{r})$ (in microvolts) as a function of $x$ (in $\mu$m), calculated at the side edges of the graphene plasmon waveguide (GPW), i.e. at $y = 0$ (solid line) and $y = W$ (dashed line). These numerical results have been calculated by setting $\xi = 1/2$ and $\alpha = \pi/4$ in Eq. (13). The other parameters are: $W = 1$ $\mu$m, $d = 10$ nm, $\varepsilon_2 = 3.9$, $\bar{n} = 10^{12}$ cm$^{-2}$, $\upsilon = 250$ cm$^2$/s, and $\gamma = 0.1$ $\Omega_0$. Finally, we have taken $\omega/(2\pi) \cong$ 1.2 THz in Eq. (8). Note that $\omega/(2\pi)$ is 20% larger than the fundamental frequency $f$ for the laser to be able to excite the two lowest modes of the GPW. (Right vertical axis) The dashed line represents the $\xi = 0$ analytical result (15) for the same parameters used to produce the solid and dashed lines. The scale is in millivolts. In both cases, $\xi = 0$ and $\xi = 1/2$, $\alpha = \pi/4$, the value of $A$ has been chosen to yield $\delta n/\bar{n} = 1\%$. This normalization implies different values of $A$ for these two cases.

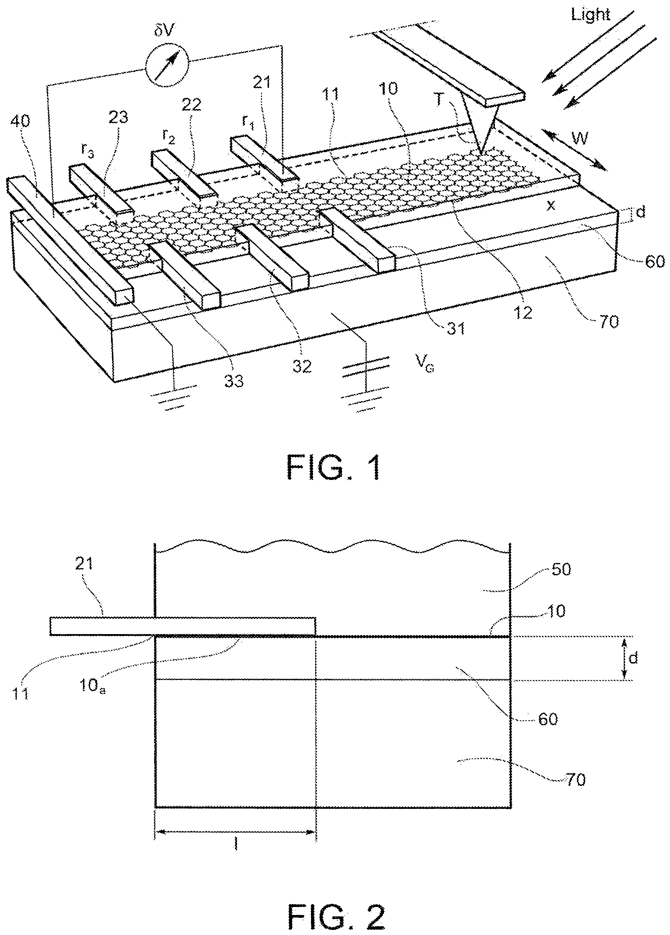

Figure 1 shows a plasmon detector according to the invention.

The detector comprises a strip-shaped waveguide 10 of material adapted to propagate a plasmon when excited by an incident beam of light. Such material could be for example a noble metal or, preferably, graphene. In Figure 1 the plasmon-launching light beam is provided by a metallized atomic force microscope tip illuminated by light, which is arranged at one end of the waveguide 10. The waveguide 10 then guides the plasmon along its length direction x. Longitudinal and transverse directions are here defined with respect to plasmon propagation.

The waveguide 10 has length $L$ and width $W$, with $L \gg W$. In Figure 1 lateral side edges of the waveguide 10 are designated with 11 and 12.

A series of probe electrodes 21, 22, 23 are placed along the side edge 11 at successive positions $\boldsymbol{r}_1$, $\boldsymbol{r}_2$, $\boldsymbol{r}_3$ with respect to the length direction of the waveguide 10. A second series of probe electrodes 31, 32, 33 are placed along the other side edge 12 opposite to the first side edge 11, at successive positions $\boldsymbol{r}_1$, $\boldsymbol{r}_2$, $\boldsymbol{r}_3$ with respect to the length direction of the waveguide 10.

Each of the probe electrodes 21-23, 31-33 is arranged in ohmic contact with a minimal area overlap 10a of the waveguide 10 at the respective side edges 11, 12 (see Fig. 2). For the purposes of the present invention, by "minimal area" it is meant that the area of contact between electrode and waveguide should be as small as possible, and preferably the smallest obtainable with the resolution of the technique that is used to fabricate and position the electrodes. For example, in the case of electron-beam lithography the best resolution that can currently be achieved would be around 100 nm. In other words, the area of contact between electrode and waveguide has characteristic dimensions $l$ (for example, side in the case of a square area, or base and height in the case of a rectangular area) such that $l \ll W$. In this way, the electrodes are as decoupled as possible from the waveguide layer and do not significantly damp the plasmon.

A reference electrode 40 is arranged in ohmic contact with one end of the waveguide 10, opposite to the tip T. The reference electrode 40 is arranged far away from the probe electrodes; in particular it is separated from the probe electrodes 21-23 and 31-33 by a distance that is greater than the plasmon extinction length in the waveguide material.

As will be explained in the following, a direct-current (DC) electric potential difference $\delta V$ is measurable between each of the probe electrodes 21-23, 31-33 and reference electrode 40; said potential difference is related to an alternating-current (AC) electric field of plasmon propagating in the waveguide 10.

The waveguide 10 is embedded between upper and lower insulating layers 50, 60 with dielectric constants $\varepsilon_1$ and $\varepsilon_2$, respectively. The layers 50, 60 could be built with material characterized by a minimal attenuation for plasmon propagation like silicon oxide, silicon nitride or preferably boron nitride. In one embodiment (not shown) the upper layer 50 could be absent; in this case the waveguide would be in contact with air.

A conductive substrate 70 (e.g. doped silicon) is joined to the lower insulating layer 60 opposite from the waveguide 10 and acts as a gate electrode. The conductive layer 70 is held at a voltage $V_G$, and is used to control the average carrier density in the waveguide. The conductive layer 70 is separated from the waveguide 10 by a distance $d$, provided by the thickness of the insulating layer 60.

All the layers 60, 70 that lie underneath the waveguide 10 perform just a mechanical support function; additionally, the conductive layer 70 performs an electrical gate function. These layers 60, 70 are not involved in the detection of the plasmon. As will be explained in the following, the detection is done along the length direction $x$ of the waveguide 10.

Regarding the waveguide 10, theoretically every plasmon waveguide material is suitable for the device design thanks to its simplicity and versatility. Graphene is preferred because plasmons in graphene are substantially different from those in noble metals. Indeed, recent scattering type near-field optical spectroscopy experiments have clearly demonstrated that plasmons in graphene display gate tunability and ultra-strong field confinement.

It is now presented a calculation of the spatially-dependent electrical signal $\delta V(r)$ recorded by the plasmon detector of Figure 1, having a graphene plasmon waveguide (hereinafter, GPW). However, it is expected that similar results may be obtained with other waveguide materials, such as noble metals.

At room temperature and for typical carrier densities ($\bar{n} \cong 10^{11}$ cm$^{-2}$ - $5 \times 10^{12}$ cm$^{-2}$), the mean-free-path $\ell_{ee}$ = $v_F \tau_{ee}$ for electron-electron collisions in graphene is short [4, 5], $\ell_{ee} \cong$ 100-150 nm. Here, $v_F \cong 10^6$ m/s is the Fermi

velocity and $\tau_{ee}$ is the electron-electron collision time. In this wide range of carrier densities and at $T$ = 300 K, transport in GPWs with characteristic dimensions

$L, W \gg \ell_{ee}$ is therefore accurately described by the continuum MDF model Hamiltonian [6] and hydrodynamic equations of motion [7].

The set of hydrodynamic equations consists of i) the continuity equation,

$$\partial_t n(\boldsymbol{r}, t) + \nabla \cdot [n(\boldsymbol{r}, t)\boldsymbol{v}(\boldsymbol{r}, t)] = 0, \qquad (1)$$

and ii) the Navier-Stokes equation [7]

$$m_c n(\boldsymbol{r}, t) D_t \boldsymbol{v}(\boldsymbol{r}, t) = -en(\boldsymbol{r}, t)\boldsymbol{E}(\boldsymbol{r}, t) + \eta\nabla^2\boldsymbol{v}(\boldsymbol{r}, t). \qquad (2)$$

In Eqs. (1)-(2), $n(\boldsymbol{r},t)$ is the carrier density and $\boldsymbol{v}(\boldsymbol{r},t)$ is the drift velocity. In Eq. (2), $m_c = \hbar\sqrt{\pi\bar{n}}/v_F$ is the graphene cyclotron mass [6], with $\bar{n} = CV_G/e$ the average electron density and $V_G$ the back-gate voltage (see Fig. 1), and $D_t \equiv \partial_t + \boldsymbol{v}(\boldsymbol{r},t) \cdot \nabla$ is the convective derivative [7]. The electric field $\boldsymbol{E}(\boldsymbol{r},t) = -\nabla\Phi(\boldsymbol{r},t)$ is the gradient of the electrostatic potential $\Phi(\boldsymbol{r},t)$. Finally, $\eta$ is the shear viscosity of the 2D electron liquid [7]. In Eq. (2), we have neglected a term due to the bulk viscosity $\zeta$ since it vanishes at long wavelengths [7]. Momentum non-conserving collisions, such as those due to the friction of the electron liquid against the disorder potential, can be taken into account by adding a term of the type $-m_c\gamma n(\boldsymbol{r},t)\boldsymbol{v}(\boldsymbol{r},t)$ on the right-hand side of Eq. (2), where $\gamma$ is a damping rate [8]. Corrections to Eq. (2), stemming from the pseudo-relativistic nature of MDF flow in graphene, can be easily incorporated into the theory [9, 10] and have been demonstrated to yield stronger rectified signals [9]. Note a) the non-linear coupling between $n(\boldsymbol{r}, t)$ and $\boldsymbol{v}(\boldsymbol{r},t)$, which is present in Eq. (1), and b) the non-linear term $[\boldsymbol{v}(\boldsymbol{r},t) \cdot \nabla]\boldsymbol{v}(\boldsymbol{r},t)$ in Eq. (2), enabled by the convective derivative.

The relation between $\Phi(\boldsymbol{r},t)$ and $n(\boldsymbol{r}, t)$ strongly depends on the screening of electron-electron interactions exerted by dielectrics and conductors near the GPW. If a metal gate is positioned underneath the GPW at a distance $d \ll W, k^{-1}$, where $k$ is the plasmon wave vector, the following local relation exists [9]:

$$\Phi(\boldsymbol{r}, t) \approx -\frac{e}{C}\delta n(\boldsymbol{r}, t), \qquad (3)$$

where $C = \varepsilon_2/(4\pi d)$ is a capacitance per unit area and $\delta n(\boldsymbol{r},t) \equiv n(\boldsymbol{r},t) - \bar{n}$. Eq. (3) greatly simplifies the theoretical analysis and, in fact, allows us to solve the problem in a fully analytical fashion, as we now detail.

Eqs. (1)-(3) need to be accompanied by a suitable set of boundary conditions, which describe the behaviour of the normal and tangent components of the fluid velocity at the GPW boundaries. Following Ref. 11, we fix $v_y(x,y = 0,W) = 0$ and $\partial_x v_y(x,y = 0,W) + \partial_y v_x(x,y = 0,W) = 0$.

We proceed by solving Eq. (1)-(3) in a perturbative fashion.

We use the following ansatz

$$n(\boldsymbol{r}, t) = \bar{n} + \lambda n_1(\boldsymbol{r}, t) + \lambda^2 n_2(\boldsymbol{r}, t) + \ldots$$

$$\boldsymbol{v}(\boldsymbol{r}, t) = \lambda \boldsymbol{v}_1(\boldsymbol{r}, t) + \lambda^2 \boldsymbol{v}_2(\boldsymbol{r}, t) + \ldots$$

$$\Phi(\boldsymbol{r}, t) = \lambda \Phi_1(\boldsymbol{r}, t) + \lambda^2 \Phi_2(\boldsymbol{r}, t) + \ldots, \qquad (4)$$

where $\lambda$ is a bookkeeping parameter that will be set to unity at the end of calculations.

The first-order in $\lambda$ (i.e. linearized) equations read

$$\partial_t n_1(\boldsymbol{r}, t) + \nabla \cdot [\bar{n}\boldsymbol{v}_1(\boldsymbol{r}, t)] = 0 \qquad (5)$$

and

$$\partial_t \boldsymbol{v}_1(\boldsymbol{r}, t) = \frac{e}{m_c}\nabla\Phi_1(\boldsymbol{r}, t) - \gamma\boldsymbol{v}_1(\boldsymbol{r}, t) + v\nabla^2\boldsymbol{v}_1(\boldsymbol{r}, t), \qquad (6)$$

where $\upsilon = \eta/(\bar{n}m_c)$ is the kinematic viscosity [7]. The latter can be calculated in a generalized relaxation time approximation. In general, $\eta$ is a function of frequency $\omega$, and so is $\upsilon$. For hydrodynamics to be valid it must also be $\omega\tau_{ee} \ll 1$, where

$\omega$ is the frequency of the collective modes supported by Eqs. (5)-(6). In this limit, $\upsilon \cong v_{\mathrm{F}}^2\tau_{\mathrm{ee}}/4,$ yielding $\upsilon \cong 250$ cm²/s. Note that the last term in Eq. (6) yields a non-local correction to the Drude formula, i.e. $\sigma(q,\omega) = i(D_0/\pi)/(\omega + i\gamma + i\upsilon q^2)$, where $D_0 = \pi\bar{n}e^2/m_c$ is the Drude weight.

It is easy to show that Eqs. (5)-(6) support plasmon modes that propagate along the $\hat{x}$ direction and are confined in the $\hat{y}$ direction. These modes are therefore labelled by a wave number k and a discrete index $n = 0, 1, 2, ...$ and their dispersion is given by

$$\omega_n(k) = \sqrt{s^2 K_n^2 - \frac{(\gamma + \upsilon K_n^2)^2}{4}} - i\frac{\gamma + \upsilon K_n^2}{2}, \qquad (7)$$

where $K_n^2 = k^2 + n^2\pi^2/W^2$ and $s = \sqrt{e^2\bar{n}/(Cm_c)}$ is the hydrodynamic speed of sound. For future purposes, it is useful to introduce $q_n \equiv \pi n/W$ and the characteristic frequency $\Omega_0 \equiv s/W$. Switching off external ($\gamma$) and internal ($\upsilon$) dissipative mechanisms-by setting $\gamma, \upsilon \to 0$ in Eq. (7)-we find the expected result $\omega_n(k) = sK_n$. The lowest-energy $n = 0$ mode has an acoustic dispersion due to the screening exerted by the back gate, i.e. Eq. (3). Modes with $n \neq 0$ are gapped, i.e. $\omega_n(k \to 0) = n\pi\Omega_0$. We note that the fundamental frequency is $f \equiv \omega_{n=1}/(2\pi) = \Omega_0/2 \cong 1.0$ THz for $W = 1$ μm, $d = 10$ nm, $\varepsilon_2 = 3.9$, and $\bar{n} = 10^{12}$ cm⁻². In the local capacitance approximation (3) the results do not depend on $\varepsilon_1$.

When the $n$-th eigenmode of the GPW is excited by an external perturbation with frequency $\omega$, it propagates with a complex wave number

$$k_n(\omega) = \sqrt{\frac{\omega^2 + i\omega\gamma}{s^2 - i\upsilon\omega} - q_n^2}. \qquad (8)$$

The wave number, $\mathfrak{Re}(k_n)$, and inverse damping ratio, $\gamma_n^{-1} \equiv \mathfrak{Re}(k_n)/= \mathfrak{Im}(k_n),$ of the launched plasmon depend only on the excitation frequency $\omega$ and not on details of the tip-sample coupling [12-16].

Physically, the dimensionless number $\gamma_n^{-1}$ is a measure of the plasmon extinction length $\ell_n \equiv 1/\mathfrak{Im}(k_n) = \gamma_n^{-1}\lambda_n/(2\pi)$ in units of the plasmon wavelength $\lambda_n = 2\pi/\mathfrak{Re}(k_n)$. With the value of $\upsilon$ given above and $\gamma = 0.1\,\Omega_0$, the inverse damping ratio of the $n = 0$ mode is $\gamma_0^{-1} \cong 25$, while $\gamma_1^{-1} \cong 8$ for $n = 1$.

At second order in $\lambda$ we obtain the following equations:

$$\partial_t n_2(\mathbf{r},t) + \nabla \cdot [\bar{n}\mathbf{v}_2(\mathbf{r},t) + n_1(\mathbf{r},t)\mathbf{v}_1(\mathbf{r},t)] = 0 \qquad (9)$$

and

$$\partial_t \mathbf{v}_2(\mathbf{r},t) - \frac{e}{mc}\nabla\Phi_2(\mathbf{r},t) + \gamma\mathbf{v}_2(\mathbf{r},t) - \upsilon\nabla^2\mathbf{v}_2(\mathbf{r},t)$$
$$= -\upsilon\frac{n_1(\mathbf{r},t)}{\bar{n}}\nabla^2\mathbf{v}_1(\mathbf{r},t) - \epsilon[\mathbf{v}_1(\mathbf{r},t) \cdot \nabla]\mathbf{v}_1(\mathbf{r},t). \qquad (10)$$

In writing Eq. (10) we have used Eq. (6). We urge the reader to note that the term $[\mathbf{v}_1(\mathbf{r},t) \cdot \nabla]\mathbf{v}_1(\mathbf{r},t)$ in the right-hand side of Eq. (10), which has a convective origin, has been multiplied by a dimensionless parameter $\epsilon$. Results of the standard Drude theory can be recovered by setting $\upsilon = \epsilon = 0$ below.

At this stage, it is useful to define the quantities $\delta V(r)$ and $\delta v(r)$ as the averages over one period $T = 2\pi/\omega$ of the external perturbation of the quantities $\Phi_2$ and $v_2$, respectively: $\delta V(r) \equiv \langle\Phi_2(r,t)\rangle$ and $\delta v \equiv \langle v_2(r,t)\rangle$, where

$$\langle f(r,t)\rangle \equiv T^{-1}\int_0^T f(r,t)dt$$

denotes temporal averaging.

Averaging over time Eqs. (9)-(10) we obtain:

$$\nabla \cdot \delta v(r) = -\frac{1}{\bar{n}}\nabla \cdot \langle n_1(r,t)v_1(r,t)\rangle \qquad (11)$$

and

$$-\frac{e}{m_c}\nabla\delta V(r) + \gamma\delta v(r) - \upsilon\nabla^2\delta v(r)$$

$$= -\epsilon\langle[v_1(r,t) \cdot \nabla]v_1(r,t)\rangle - \frac{\upsilon}{\bar{n}}\langle n_1(r,t)\nabla^2 v_1(r,t)\rangle. \qquad (12)$$

Eqs. (11)-(12) are crucial since they relate the second-order quantities $\delta V$ and $\delta v$ to the quantities $n_1(r,t)$ and $v_1(r,t)$, which have been calculated in the linearized theory. Furthermore, they can be used to calculate the DC signal $\delta V(r)$ in response to plasmon propagation in any desired geometry. As stated above, the quantity $\delta V(r)$ can be measured by employing a suitable set of ohmic contacts, as in Fig. 1.

We now use these equations to evaluate $\delta V(r)$ for the experimentally relevant case in which plasmons are launched at a specific location in space in the GPW. We denote by $r^* = (0,y^*)$ with $0 \leq y^* \leq W$ such position. The DC potential far away from the launch point, i.e. $\delta V(r)$ for $|r| >> |r^*|$, can be calculated according to the following procedure, which is typical of a scattering problem. a) It is easy to check that the solution of the linear-response problem posed by Eqs. (5)-(6) yields an irrotational vector field $v_1(r,t)$ at large distances $|r| >> |r^*|$. In scattering theory, this is the so-called asymptotic solution, which we denote by $v_1^{(a)}(r,t)$. This implies that $v_1^{(a)}(r,t)$ can be written as the gradient of a scalar function. b) Let us imagine that an external perturbation with frequency $\omega$ launches, for example, an arbitrary linear combination with complex coefficients of the $n = 0$ and $n = 1$ GPW modes. Because of a), we can write the corresponding asymptotic velocity field as

$$v_1^{(a)}(r,t) = \frac{A}{2}\nabla_r[(1 - \xi)\varphi_0(y)e^{i\bar{k}_0 x}e^{-\beta_0 x}$$

$$+ \xi e^{i\alpha}\varphi_1(y)e^{i\bar{k}_1 x}e^{-\beta_1 x}]e^{-i\omega t} + c.c., \qquad (13)$$

where $x > 0$ and

$$\varphi_n(y) = \frac{1}{\sqrt{W}}\times\begin{cases}1, & \text{for } n = 0 \\ \sqrt{2}\cos[n\pi y/W], & \text{for } n \neq 0\end{cases}. \qquad (14)$$

In Eq. (13) $A = \bar{v}W^{3/2}$ is an unknown amplitude (here $\bar{v}$ has physical dimensions of a velocity), which can be estimated as discussed below, $\bar{k}_n = \mathfrak{Re}[k_n(\omega)]$ and $\beta_n = \mathfrak{Im}[k_n(\omega)]$ with $k_n(\omega)$ as in Eq. (8), $\xi \in [0,1]$ is a real parameter that allows us to interpolate between the case in which only the $n = 0$ mode is launched ($\xi = 0$) and the case in which only the $n = 1$ mode is launched ($\xi = 1$), and $e^{i\alpha}$ (with $\alpha$ real) is the relative phase between the two modes. c) With the velocity field in Eq. (13), one can easily calculate the asymptotic density profile $n_1^{(a)}(r,t)$ by using Eq. (5).

d) The quantities $n_1^{(a)}(r,t)$ and $v_1^{(a)}(r,t)$ are then used to calculate the temporal averages that appear on the right-hand side of Eqs. (11)-(12). e) Finally, $\delta V(r)$ is found by solving Eqs. (11)-(12).

Simple and compact analytical expressions, obtained by following steps a)-e), are available for $\delta V(r)$ in the extreme cases $\xi = 0$ and $\xi = 1$. For $\xi = 0$ we find

$$\delta V(\boldsymbol{r}) = \nu e^{-2\beta_0 x} W^2 \frac{(\bar{k}_0^2+\beta_0^2)[\epsilon\omega\beta_0+\bar{k}_0\gamma+\nu\bar{k}_0(\bar{k}_0^2-3\beta_0^2)]}{4\beta_0\omega} \tag{15}$$

and for $\xi = 1$

$$\delta V(\boldsymbol{r}) = \nu e^{-2\beta_1 x} W^2 \left\{ \frac{(\epsilon\omega\beta_1^2+\beta_1\bar{k}_1\gamma)(\beta_1^2+\bar{k}_1^2+q_1^2)+\nu\beta_1\bar{k}_1(\bar{k}_1^4-3\beta_1^4+q_1^4-2\bar{k}_1^2\beta_1^2-6q_1^2\beta_1^2+2q_1^2\bar{k}_1^2)}{4\beta_1^2\omega} \right. +$$

$$\left. \frac{\varphi_2(y)}{\sqrt{2}}\sqrt{W}\frac{[\epsilon\omega(\beta_1^2-q_1^2)+\beta_1\bar{k}_1\gamma](\beta_1^2+\bar{k}_1^2-q_1^2)+\nu\beta_1\bar{k}_1(\bar{k}_1^4-3\beta_1^4-3q_1^4-2\bar{k}_1^2\beta_1^2+6q_1^2\beta_1^2+6q_1^2\bar{k}_1^2)}{4\omega(\beta_1^2-q_1^2)} \right\}$$

$$\tag{16}$$

Here $v = m_c|A|^2 W^{-3}/e = m_c\overline{v^2}/e$ has physical dimensions of a voltage. Once again, the results of Drude theory can be obtained by setting $\upsilon = \varepsilon = 0$.

In the general case $\xi \neq 0, 1$ the mathematical expression for $\delta V(\boldsymbol{r})$ is very cumbersome and will not be reported here. Interestingly, for $\xi \neq 0, 1$ an oscillatory term with spatial periodicity $2\pi/(\bar{k}_0 - \bar{k}_1)$ appears in $\delta V(\boldsymbol{r})$ along the $\hat{\boldsymbol{x}}$ direction due to interference of the two modes in Eq. (13). Illustrative numerical results can be found in Fig. 3. Notice that the DC signal is of the order of 150 $\mu$V-40 mV and that its spatial extension is of the order of 10 $\mu$m. The DC potentials on the side edges 11, 12 are not equal in the case $\xi \neq 0, 1$ since Eq. (13) is a superposition of modes with different parity. The quantity $A$ in Eq. (13) was estimated with reference to Refs. 12-16, where a metallized tip is used to launch plasmons. In this case, $A$ can be calculated starting from the amplitude of density oscillations $\delta n/\bar{n}$ created by the tip at $\boldsymbol{r} = \boldsymbol{r}^*$. The results in Fig. 3 have been produced by using $\delta n/\bar{n} = 2\%$. We emphasize that this "normalization" condition yields different values of $A$ for different values of $\xi, \alpha$. In other words, $A$ measures how well the tip couples to the linear combination of modes in Eq. (13). The $\xi = 0$ mode has a much better coupling to the tip (and therefore yields a much larger DC signal) than the linear superposition of $n = 0$ and $n = 1$ modes corresponding to $\xi = 1/2$ and $\alpha = \pi/4$.

References

1. Fakonas et al. Nature Photonics 2014, 8, p. 317
2. Heeres et al. Nano Letters 2010, 10, p. 661
3. Falk et al. Nature Physics 2009, 5, p. 475
4. Li and Das Sarma, Phys. Rev. B 2013, 87, 085406
5. Polini and Vignale, arXiv:1404.5728
6. Castro Neto et al. Rev. Mod. Phys. 2009, 81, p. 109
7. Landau and Lifshitz, Fluid Mechanics (Pergamon, New York, 1987)
8. Selberherr, Analysis and Simulation of Semiconductor Devices (Springer-Verlag/Wien, Wien, 1984); Vasileska and Goodnick, Computational Electronics (Morgan & Claypool, USA, 2006)
9. Tomadin and Polini, Phys. Rev. B 2013, 88, 205426
10. Svintsov et al. Phys. Rev. B 2013, 88
11. Tomadin et al. arXiv:1401.0938
12. Fei et al. Nano Lett. 2011, 11, 4701
13. Fei et al. Nature 2012, 487, 82
14. Chen et al. Nature 2012, 487, 77
15. Alonso-González et al. Science 2014, 344, 1369 16. Woessner et al. arXiv:1409.5674

Claims

**1.** A plasmon detector comprising
a strip-shaped waveguide (10) of material adapted to propagate a plasmon when excited by an incident beam of light, said waveguide being adapted to guide the plasmon along its length direction (*x*),
at least one probe electrode (21, 22, 23; 31, 32, 33) arranged in ohmic contact with a minimal area overlap (10a)

of the waveguide (10) at one of lateral side edges (11, 12) thereof, and
a reference electrode (40) arranged in ohmic contact with one of opposite ends of the waveguide,
wherein a DC electric potential difference (($\delta V$) is measurable between probe electrode (21, 22, 23; 31, 32, 33) and reference electrode (40), said potential difference being related to an AC electric field of plasmon propagating in the waveguide (10),
said detector being **characterized by** further comprising an insulating layer (60) joined to the waveguide layer (10) and a conductive layer (70) joined to the insulating layer (60) opposite from the waveguide (10) and acting as a gate electrode,
wherein the conductive layer (70) is separated from the waveguide by a distance $d$ such that
$d$ « $W,$ and
$d$ « $k^{-1}$,
where k is the plasmon wave vector, and W is the width of the waveguide.

2. A detector according to claim 1, wherein said waveguide has a length $L$ and width $W$ such that
$L$ » $W,$ and
$W$ » $\ell_{ee}$,
where $\ell_{ee}$ is the mean-free path for electron-electron collisions in the waveguide material.

3. A detector according to claim 1 or 2, wherein said minimal area overlap (10a) of the waveguide (10) with which the at least one probe electrode (21, 22, 23; 31, 32, 33) is in ohmic contact has characteristic dimensions $l$ such that $l$ « $W$.

4. A detector according to any of the preceding claims, wherein the reference electrode (40) is separated from the at least one probe electrode (21, 22, 23; 31, 32, 33) by a distance that is greater than the plasmon extinction length in the waveguide material.

5. A detector according to any of the preceding claim, wherein the waveguide material is graphene.

6. A method for plasmon detection using
a strip-shaped waveguide (10) of material adapted to propagate a plasmon when excited by an incident beam of light, said waveguide being adapted to guide the plasmon along its length direction (x),
at least one probe electrode (21, 22, 23; 31, 32, 33) arranged in ohmic contact with a minimal area (10a) of the waveguide (10) at one of lateral side edges (11, 12) thereof,
a reference electrode (40) arranged in ohmic contact with one of opposite ends of the waveguide (10),
an insulating layer (60) joined to the waveguide layer (10) and a conductive layer (70) joined to the insulating layer (60) opposite from the waveguide (10) and acting as a gate electrode,
wherein the conductive layer (70) is separated from the waveguide by a distance $d$ such that
$d$ « $W,$ and
$d$ « $k^{-1}$,
where k is the plasmon wave vector, and W is the width of the waveguide,
said method being **characterized by** the following steps:

   launching a plasmon by illuminating one end of the waveguide (10) opposite to the reference electrode (40), and measuring a DC electric potential difference ($\delta V$) between probe electrode (21, 22, 23; 31, 32, 33) and reference electrode (40), said potential difference being related to an AC electric field of plasmon propagating in the waveguide (10).

7. A method according to claim 6, wherein said waveguide has a length $L$ and width $W$ such that
$L$ » $W,$ and
$W$ » $\ell_{ee}$,
where $\ell_{ee}$ is the mean-free path for electron-electron collisions in the waveguide material.

8. A method according to claim 6 or 7, wherein said minimal area overlap (10a) of the waveguide (10) with which the at least one probe electrode is in ohmic contact has characteristic dimensions $l$ such that $l$ « $W$.

9. A method according to any of claims 6 to 8, wherein the reference electrode (40) is separated from the at least one probe electrode (21, 22, 23; 31, 32, 33) by a distance that is greater than the plasmon extinction length in the waveguide material.

**10.** A method according to any of claims 6 to 9, wherein the waveguide material is graphene.

**Patentansprüche**

**1.** Plasmonendetektor, aufweisend
einen streifenförmigen Wellenleiter (10) aus Material, das zur Ausbreitung eines Plasmons ausgelegt ist, wenn dieses durch einen einfallenden Lichtstrahl angeregt wird, wobei der Wellenleiter dazu geeignet ist, das Plasmon entlang seiner Längsrichtung (x) zu leiten,
mindestens eine Sondenelektrode (21, 22, 23; 31, 32, 33), die in ohmschem Kontakt mit einer minimalen Flächenüberschneidung (10a) des Wellenleiters (10) an einer seiner seitlichen Seitenkanten (11, 12) angeordnet ist, und eine Referenzelektrode (40), die in ohmschem Kontakt mit einem der entgegengesetzten Enden des Wellenleiters angeordnet ist,
wobei eine elektrische Gleichspannungspotentialdifferenz ($\delta$V) zwischen Sondenelektrode (21, 22, 23; 31, 32, 33) und Referenzelektrode (40) messbar ist, wobei die Potentialdifferenz mit einem sich im Wellenleiter (10) ausbreitenden elektrischen Plasmon-Wechselstromfeld zusammenhängt,
wobei der Detektor **dadurch gekennzeichnet ist, dass** er weiter eine mit der Wellenleiterschicht (10) verbundene Isolierschicht (60) und eine an einer dem Wellenleiter (10) entgegengesetzten Seite mit der Isolierschicht (60) verbundene leitfähige Schicht (70) umfasst, die als Gateelektrode wirkt,
wobei die leitfähige Schicht (70) von dem Wellenleiter durch eine Entfernung $d$ getrennt ist, derart dass
$d << W$ und
$d << k^{-1}$
ist, wobei $k$ der Plasmonenwellenvektor und $W$ die Breite des Wellenleiters ist.

**2.** Detektor nach Anspruch 1, wobei der Wellenleiter eine Länge $L$ und eine Breite $W$ aufweist, derart dass
$L >> W$ und
$W >> l_{ee}$
ist, wobei $l_{ee}$ die mittlere freie Weglänge für Elektronen-Elektronen-Kollisionen im Wellenleitermaterial ist.

**3.** Detektor nach Anspruch 1 oder 2, wobei die minimale Flächenüberschneidung (10a) des Wellenleiters (10), mit welcher die mindestens eine Sondenelektrode (21, 22, 23; 31, 32, 33) in ohmschem Kontakt steht, charakteristische Abmessungen $l$ aufweist, derart, dass $l << W$ ist.

**4.** Detektor nach einem der vorangehenden Ansprüche, wobei die Referenzelektrode (40) von der mindestens einen Sondenelektrode (21, 22, 23; 31, 32, 33) durch eine Entfernung getrennt ist, welche größer als die Plasmonenextinktionslänge des Wellenleitermaterials ist.

**5.** Detektor nach einem der vorangehenden Ansprüche, wobei das Wellenleitermaterial Graphen ist.

**6.** Verfahren zur Plasmonendetektion unter Verwendung
eines streifenförmigen Wellenleiters (10) aus Material, das zur Ausbreitung eines Plasmons ausgelegt ist, wenn dieses durch einen einfallenden Lichtstrahl angeregt wird, wobei der Wellenleiter dazu geeignet ist, das Plasmon entlang seiner Längsrichtung (x) zu leiten,
mindestens einer Sondenelektrode (21, 22, 23; 31, 32, 33), die in ohmschem Kontakt mit einer minimalen Flächenüberschneidung (10a) des Wellenleiters (10) an einer seiner seitlichen Seitenkanten (11, 12) angeordnet ist, und einer Referenzelektrode (40), die in ohmschem Kontakt mit einem der entgegengesetzten Enden des Wellenleiters (10) angeordnet ist,
einer mit der Wellenleiterschicht (10) verbundenen Isolierschicht (60) und einer an einer dem Wellenleiter (10) entgegengesetzten Seite mit der Isolierschicht (60) verbundenen leitfähigen Schicht (70), die als Gateelektrode wirkt,
wobei die leitfähige Schicht (70) von dem Wellenleiter durch eine Entfernung $d$ getrennt ist, derart, dass
$d « W$ und
$d << k^{-1}$
ist, wobei $k$ der Plasmonenwellenvektor und $W$ die Breite des Wellenleiters ist,
wobei das Verfahren durch die folgenden Schritte gekennzeichnet ist:

Starten eines Plasmons durch Beleuchten eines Endes des Wellenleiters (10), welches der Referenzelektrode (40) entgegengesetzt ist, und
Messen einer elektrischen Gleichspannungspotentialdifferenz ($\delta$V) zwischen Sondenelektrode (21, 22, 23; 31, 32, 33) und Referenzelektrode (40), wobei die Potentialdifferenz mit einem sich im Wellenleiter (10) ausbreitenden elektrischen Plasmon-Wechselstromfeld zusammenhängt.

7. Verfahren nach Anspruch 6, wobei der Wellenleiter eine Länge $L$ und eine Breite $W$ aufweist, derart, dass $L >> W$ und $W >> l_{ee}$ ist, wobei $l_{ee}$ die mittlere freie Weglänge für Elektronen-Elektronen-Kollisionen im Wellenleitermaterial ist.

8. Verfahren nach Anspruch 6 oder 7, wobei die minimale Flächenüberschneidung (10a) des Wellenleiters (10), mit welcher die mindestens eine Sondenelektrode (21, 22, 23; 31, 32, 33) in ohmschem Kontakt steht, charakteristische Abmessungen $l$ aufweist, wonach $l << W$ ist.

9. Verfahren nach einem der Ansprüche 6 bis 8, wobei die Referenzelektrode (40) von der mindestens einen Sondenelektrode (21, 22, 23; 31, 32, 33) durch eine Entfernung getrennt ist, welche größer als die Plasmonenextinktionslänge des Wellenleitermaterials.

10. Verfahren nach einem der Ansprüche 6 bis 9, wobei das Wellenleitermaterial Graphen ist.

## Revendications

1. Détecteur de plasmon comprenant
   un guide d'ondes en forme de bande (10) d'un matériau adapté pour propager un plasmon lorsqu'il est excité par un faisceau incident de lumière, ledit guide d'ondes étant adapté pour guider le plasmon le long de sa direction en longueur (x),
   au moins une électrode sonde (21, 22, 23 ; 31, 32, 33) agencée en contact ohmique avec une zone minimale de chevauchement (10a) du guide d'ondes (10) au niveau de l'un de bords de côté latéral (11, 12) de celle-ci, et
   une électrode de référence (40) agencée en contact ohmique avec l'une d'extrémités opposées du guide d'ondes,
   dans lequel une différence de potentiel électrique CC ($\delta$V) est mesurable entre une électrode sonde (21, 22, 23 ; 31, 32, 33) et une électrode de référence (40), ladite différence de potentiel étant liée à un champ électrique CA de plasmon se propageant dans le guide d'ondes (10),
   ledit détecteur étant **caractérisé en ce qu'**il comprend en outre une couche isolante (60) réunie à la couche de guide d'ondes (10) et une couche conductrice (70) réunie à la couche isolante (60) à l'opposé du guide d'ondes (10) et agissant en tant qu'une électrode grille,
   dans lequel la couche conductrice (70) est séparée du guide d'ondes par une distance $d$, de telle sorte que
   $d$ « $W,$ et
   $d$ « $k^{-1}$,
   où k est le vecteur d'onde du plasmon, et $W$ est la largeur du guide d'ondes.

2. Détecteur selon la revendication 1, dans lequel ledit guide d'ondes a une longueur $L$ et une largeur $W,$ de telle sorte que
   $L$ » $W,$ et
   $W$ » $\ell_{ee}$,
   où $\ell_{ee}$ est le libre parcours moyen pour des collisions électron-électron dans le matériau de guide d'ondes.

3. Détecteur selon la revendication 1 ou 2, dans lequel ladite zone minimale de chevauchement (10a) du guide d'ondes (10) avec laquelle l'au moins une électrode sonde (21, 22, 23 ; 31, 32, 33) est en contact ohmique a des dimensions de caractéristique $l$ de telle sorte que $l$ « $W.$

4. Détecteur selon l'une quelconque des revendications précédentes, dans lequel l'électrode de référence (40) est séparée de l'au moins une électrode sonde (21, 22, 23 ; 31, 32, 33) par une distance qui est supérieure à une longueur d'extinction du plasmon dans le matériau de guide d'ondes.

5. Détecteur selon l'une quelconque des revendications précédentes, dans lequel le matériau de guide d'ondes est du graphène.

6. Procédé de détection de plasmon utilisant
   un guide d'ondes en forme de bande (10) d'un matériau adapté pour propager un plasmon lorsqu'il est excité par un faisceau incident de lumière, ledit guide d'ondes étant adapté pour guider le plasmon le long de sa direction en longueur (x),

au moins une électrode sonde (21, 22, 23 ; 31, 32, 33) agencée en contact ohmique avec une zone minimale (10a) du guide d'ondes (10) au niveau de l'un de bords de côté latéral (11, 12) de celle-ci,

une électrode de référence (40) agencée en contact ohmique avec l'une d'extrémités opposées du guide d'ondes (10),

une couche isolante (60) réunie à la couche de guide d'ondes (10) et une couche conductrice (70) réunie à la couche isolante (60) à l'opposé du guide d'ondes (10) et agissant en tant qu'une électrode grille,

dans lequel la couche conductrice (70) est séparée du guide d'ondes par une distance $d$, de telle sorte que

$d \ll W,$ et

$d \ll k^{-1},$

où k est le vecteur d'onde du plasmon, et $W$ est la largeur du guide d'ondes,

ledit procédé étant **caractérisé par** les étapes suivantes :

le lancement d'un plasmon par éclairement d'une extrémité du guide d'ondes (10) opposée à l'électrode de référence (40), et

la mesure d'une différence de potentiel électrique CC ($\delta$V) entre une électrode sonde (21, 22, 23 ; 31, 32, 33) et une électrode de référence (40), ladite différence de potentiel étant liée à un champ électrique CA de plasmon se propageant dans le guide d'ondes (10).

7. Procédé selon la revendication 6, dans lequel ledit guide d'ondes a une longueur $L$ et une largeur $W,$ de telle sorte que

$L \gg W,$ et

$W \gg \ell_{ee},$

où $\ell_{ee}$ est le libre parcours moyen pour des collisions électron-électron dans le matériau de guide d'ondes.

8. Procédé selon la revendication 6 ou 7, dans lequel ladite zone minimale de chevauchement (10a) du guide d'ondes (10) avec laquelle l'au moins une électrode sonde est en contact ohmique a des dimensions de caractéristique $l$ de telle sorte que $l \ll W.$

9. Procédé selon l'une quelconque des revendications 6 à 8, dans lequel l'électrode de référence (40) est séparée de l'au moins une électrode sonde (21, 22, 23 ; 31, 32, 33) par une distance qui est supérieure à une longueur d'extinction du plasmon dans le matériau de guide d'ondes.

10. Procédé selon l'une quelconque des revendications 6 à 9, dans lequel le matériau de guide d'ondes est du graphène.

FIG. 1

FIG. 2

FIG. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2004173865 A

- US 7495230 B

### Non-patent literature cited in the description

- **FAKONAS et al.** *Nature Photonics,* 2014, vol. 8, 317
- **HEERES et al.** *Nano Letters,* 2010, vol. 10, 661
- **FALK et al.** *Nature Physics,* 2009, vol. 5, 475
- **LI ; DAS SARMA.** *Phys. Rev. B,* 2013, vol. 87, 085406
- **POLINI ; VIGNALE.** *arXiv:1404.5728*
- **CASTRO NETO et al.** *Rev. Mod. Phys.,* 2009, vol. 81, 109
- **LANDAU ; LIFSHITZ.** Fluid Mechanics. Pergamon, 1987
- **SELBERHERR.** Analysis and Simulation of Semiconductor Devices. Springer-Verlag/Wien, 1984
- **VASILESKA ; GOODNICK.** Computational Electronics. Morgan & Claypool, 2006
- **TOMADIN ; POLINI.** *Phys. Rev. B,* 2013, vol. 88, 205426
- **SVINTSOV et al.** *Phys. Rev. B,* 2013, vol. 88
- **TOMADIN et al.** *arXiv:1401.0938*
- **FEI et al.** *Nano Lett.,* 2011, vol. 11, 4701
- **FEI et al.** *Nature,* 2012, vol. 487, 82
- **CHEN et al.** *Nature,* 2012, vol. 487, 77
- **ALONSO-GONZÁLEZ et al.** *Science,* 2014, vol. 344, 1369-16
- **WOESSNER et al.** *arXiv:1409.5674*